# EUROPÄISCHE PATENTSCHRIFT

(11) **EP 0 353 583 B1**
(45) Veröffentlichungstag und Bekanntmachung des Hinweises auf die Patenterteilung: **29.09.1993**
(21) Anmeldenummer: 89113591.5
(22) Anmeldetag: 24.07.1989
(51) Int. Cl.: C08J 3/28, H01L 21/312, B05D 3/06, G03F 7/075

(54) **Verfahren zur Erzeugung dünner Schichten auf Siliconbasis**
Method for making thin silicone coatings
Procédé de fabrication de couches minces de revêtement à base de polysiloxanes

(30) Priorität: 05.08.1988 DE 3826713
(43) Veröffentlichungstag der Anmeldung: 07.02.1990
(73) Patentinhaber: SIEMENS AKTIENGESELLSCHAFT, 80333 München (DE)
(72) Erfinder: Henkel, Hans-Joachim, Dr., D-8520 Erlangen (DE); Roth, Wolfgang, Dr., D-8525 Uttenreuth (DE); Markert, Helmut, Dr., D-8500 Nürnberg 40 (DE); Kautek, Wolfgang, Dr., D-1000 Berlin 45 (DE)

(56) Entgegenhaltungen:
- EP-A- 0 202 803
- DE-A- 2 447 790
- PATENT ABSTRACTS OF JAPAN, Band 9, Nr. 4 (E-288)[1727], 10. Januar 1985; & JP-A-59 154 029 (NIPPON DENSHIN DENWA KOSHA) 03-09-1984
- CHEMICAL ABSTRACTS, Band 98, 1983, Seite 258, Zusammenfassung Nr. 93785w, Columbus, Ohio, US; & JP-A-57 181 326 (MITSUBISHI HEAVY INDUSTRIES LTD) 08-11-1982
- IBM TECHNICAL DISCLOSURE BULLETIN, Band 26, Nr. 10B, März 1984, Seite 5683, New York, US; D.C. HOFER et al.: "Silane polymer excimer laser photoresist"

## Beschreibung

Die Erfindung betrifft ein Verfahren zur Erzeugung dünner Schichten auf Siliconbasis durch Photohärtung von Organosiloxanen sowie die Verwendung derartiger dünner Schichten.

Dünne Schichten auf Siliconbasis dienen unter anderem als Oberflächenbeschichtung für die verschiedensten Materialien. Mit Siliconen können Papier und hochpolymere Stoffe beschichtet und Metalle lackiert werden, auch können Siliconschichten als Primärbeschichtung von Lichtwellenleitern dienen (siehe dazu beispielsweise: "Adhäsion", 29. Jahrg. (1985), Nr. 10, Seiten 28 bis 35, sowie "Plaste und Kautschuk", 34. Jahrg. (1987), Nr. 5, Seiten 183 bis 190).

Ungesättigte Organosiloxane werden üblicherweise thermisch unter Zusatz geeigneter Initiatoren, wie Peroxide, oder Katalysatoren, wie Platinverbindungen, polymerisiert und vernetzt. Auch die photochemische Polymerisation und Vernetzung ungesättigter Organosiloxane ist bekannt, d.h. die Bestrahlung mit Licht, insbesondere UV-Licht. Ohne Zusatz von Photoinitiatoren und/oder Photosensibilisatoren sind dazu jedoch lange Bestrahlungszeiten erforderlich. Die direkte Photovernetzung von Organosiloxanen, ohne Zusatz von Photoinitiatoren bzw. Photosensibilisatoren, erfordert das Vorhandensein von Chromophoren im Molekül, die mit dem Licht in Wechselwirkung treten. Derartige Strukturelemente sind beispielsweise Maleinimidgruppen.

Nicht-funktionalisierte Organosiloxane, wie Poly(dimethylsiloxan) und Poly(methylphenylsiloxan), werden bei der Bestrahlung mit UV-Licht verfärbt; eine Gelbildung, d.h. Vernetzung, erfolgt nur in Anwesenheit von Luftsauerstoff (siehe: "Polymer Preprints", Vol. 20 (1979), No. 2, Seiten 443 bis 446). Beim Bestrahlen mit einer Quecksilber-Niederdrucklampe bildet Poly(methylphenylsiloxan) nur eine Oberflächenhaut, wobei nur teilweise eine Vernetzung erfolgt; nach einer Bestrahlungsdauer von mehr als 100 h wird eine Änderung des mittleren Molekulargewichts um weniger als 2 % festgestellt (siehe: "J. Polym. Sci. - Part A-1", Vol. 4 (1966), Seiten 2107 bis 2120).

Aus der EP-A2-0 202 803 ist ein Verfahren zur Härtung von Beschichtungen mittels Laserlicht bekannt. Dabei wird die Beschichtung, die ein flüssiges oder festes Polymer und/oder Oligomer und/oder ein Monomer sowie wenigstens einen Photoinitiator enthält, auf eine Oberfläche aufgebracht und mit UV-Laserlicht wenigstens einer vorgegebenen Wellenlänge bestrahlt, wobei die Lichtenergie bei der vorgegebenen Wellenlänge so gewählt wird, daß sie vorzugsweise vom Photoinitiator und nicht von den anderen Komponenten der Beschichtung absorbiert wird. Die Beschichtung kann unter anderem ein reaktives Oligomer in Form eines Polymers mit niederem Molekulargewicht, das funktionelle Gruppen aufweist, enthalten, beispielsweise einen Siliconpolyester.

Mit den vorstehend genannten Verfahren lassen sich aber - in technischer und wirtschaftlicher Hinsicht - keine hochreinen und thermisch stabilen Dünnschichten herstellen. Technisch nachteilig wirken sich insbesondere Verunreinigungen, bedingt durch den erforderlichen Zusatz von Photoinitiatoren und Photosensibilisatoren, aus. Bei der UV-Vernetzung ist ferner die Verfärbung, eine ungenügende Transparenz und eine nicht ausreichende thermische Stabilität, beispielsweise von aus Siliconacrylaten hergestellten dünnen Schichten, von Nachteil. Wirtschaftlich nachteilig ist vor allem die erforderliche hohe Bestrahlungsdauer (siehe dazu beispielsweise: "J. Organometal. Chem.", Vol. 148 (1978), Seiten 213 bis 223).

Aufgabe der Erfindung ist es, ein Verfahren der eingangs genannten Art in der Weise auszugestalten, daß durch Photohärtung dünne Schichten auf Siliconbasis mit hoher Reinheit, thermischer Beständigkeit und guten dielektrischen Eigenschaften bei kurzen Bestrahlungszeiten hergestellt werden können.

Dies wird erfindungsgemäß dadurch erreicht, daß nichtfunktionalisierte Organosiloxane mit Alkylgruppen oder Alkyl- und Arylgruppen photochemisch mittels Impulslaserstrahlung mit einer Wellenlänge < 400 nm polymerisiert und/oder vernetzt werden, wobei die Impulsdauer 10 ps bis 1 ms, die Impulsfrequenz 1 Hz bis 10 kHz und die Energiedichte mindestens 1 J/cm² beträgt und die Bestrahlung mit einem oder mehreren Impulsen erfolgt.

Beim erfindungsgemäßen Verfahren ist wesentlich, daß keine Zusätze, d.h. keine Photoinitiatoren und/oder Photosensibilisatoren, verwendet werden. Außerdem werden bei diesem Verfahren nicht-funktionalisierte Organosiloxane eingesetzt, d.h. Verbindungen, die keine funktionellen Gruppen aufweisen. Diese Verbindungen enthalten vielmehr lediglich Alkylgruppen oder Alkyl-und Arylgruppen. Dabei beträgt das Molverhältnis von Arylgruppen zu Alkylgruppen der eingesetzten Organosiloxane bzw. daraus hergestellter Mischungen vorteilhaft maximal 2,0; vorzugsweise beträgt das Molverhältnis 0,001 bis 0,5. Die Alkylgruppen können linearer, d.h. unverzweigter, verzweigter oder cyclischer Natur sein. Die Arylgruppen können alkylsubstituiert sein, so daß beispielsweise ein Tolylrest vorliegt, und es können auch kondensierte Systeme, wie Naphthyl, vorhanden sein.

Die Organosiloxane können linear, verzweigt oder cyclisch aufgebaut sein. Wesentlich ist, daß die Organosiloxane einen hohen Reinheitsgrad besitzen. Bei der Anwendung der erfindungsgemäß hergestellten Schichten in der Mikroelektronik beispielsweise müssen sowohl die Halbleiterfunktion beeinflussende Elemente, wie Natrium, als auch α-Strahler, wie Uran und Thorium, als auch eine Korrosion auslösende Elemente, wie Halogene, weitgehend vermieden werden.

Die Organosiloxane besitzen im allgemeinen folgende Struktur:
a) Lineare Verbindungen: 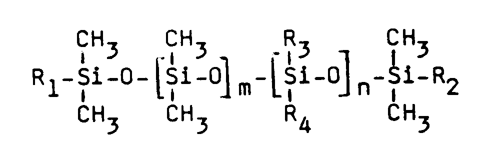 Dabei bedeuten R₁, R₂, R₃ und R₄ Alkyl oder Aryl, wobei beim Vorliegen von Arylgruppen das vorstehend genannte Verhältnis von Aryl- zu Alkylgruppen gilt; ferner gilt: m, n ≧ 0.
b) Verzweigte Verbindungen: 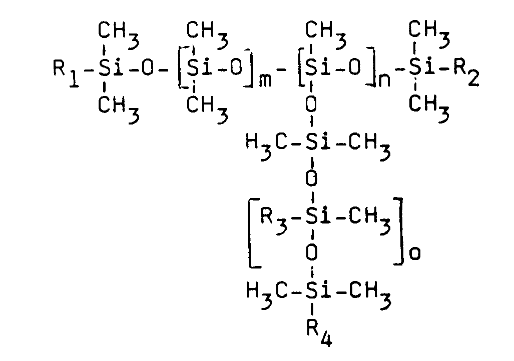 Dabei bedeuten R₁, R₂, R₃ und R₄ Alkyl oder Aryl, wobei beim Vorliegen von Arylgruppen das vorstehend genannte Verhältnis von Aryl- zu Alkylgruppen gilt; ferner gilt: m, o ≧ 0 und n ≧ 1.
c) Cyclische Verbindungen: 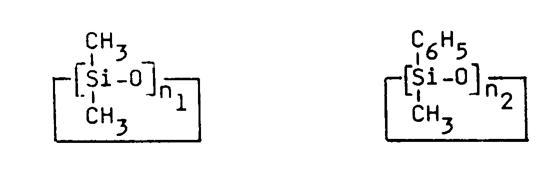 Dabei gilt: n₁ = 3 oder 4 und n₂ = 3.

Die Organosiloxane werden einer Bestrahlung mit einer Wellenlänge < 400 nm unterworfen; vorzugsweise liegt die Wellenlänge im Bereich zwischen 190 und 300 nm. Vorteilhaft wird beim erfindungsgemäßen Verfahren ein Poly(dimethylsiloxan) eingesetzt, wobei mit einer Wellenlänge von 193 nm bestrahlt wird, oder ein Poly(methylphenylsiloxan), wobei mit einer Wellenlänge von 240 bis 280 nm bestrahlt wird. Die Bestrahlung selbst erfolgt vorzugsweise in sauerstofffreier Atmosphäre. Den Organosiloxanen können - zur Vernetzungsverstärkung und/oder zur Verbesserung der Grenzflächenhaftung - vorteilhaft geringe Mengen vinylgruppenhaltiger Siloxane, wie Poly(methylvinylsiloxan), zugesetzt werden; vorzugsweise beträgt der Anteil an derartigen Siloxanen 0,5 bis 1,0 Masse-%.

Nach dem erfindungsgemäßen Verfahren werden Schichten mit einer Dicke bis zu 100 µm hergestellt. Diese Schichten weisen eine hohe Reinheit auf und sind thermisch bis über 180°C stabil, wobei vor allem die Langzeitstabilität von Bedeutung ist. Die nach dem erfindungsgemäßen Verfahren hergestellten dünnen Schichten können vorteilhaft als Passivier- und Isolierschichten für Halbleiterbauelemente und elektronische Schaltungen dienen. Ferner können diese Schichten als strukturierte Passivier- und Isolierschichten oder als Ätzmasken bei der Herstellung von Halbleiterbauelementen verwendet werden. Dazu wird bei der Herstellung der dünnen Schichten durch eine Maske bestrahlt, d.h. zwischen dem Impulslaser und dem zu bestrahlenden Organosiloxan wird eine Maske angeordnet, so daß eine bildmäßige Bestrahlung erfolgt.

Anhand von Ausführungsbeispielen soll die Erfindung noch näher erläutert werden.

### Beispiel 1

### Bestrahlung eines Poly(methylphenylsiloxans)

Ein Poly(methylphenylsiloxan) folgender Struktur 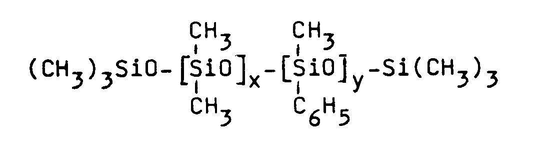
mit einem Methyl/Phenyl-Verhältnis von 20:1 und einer Viskosität von 2000 mPa.s (bei 25°C) wird mittels Spin-coating auf einen Siliciumwafer aufgebracht. Die Bestrahlung erfolgt in einer Reaktionskammer, durch die 15 min lang ein Stickstoffstrom geleitet wurde. Zur Bestrahlung dient ein mit einem Nd/YAG-Laser gepumpter Farbstofflaser, wobei folgende Bestrahlungsparameter eingehalten werden: unfokussierter Laserstrahl, Wellenlänge λ = 266 nm, Frequenz ν = 10 Hz, Impulsdauer t = 10 ns, Zahl der Impulse n = 1000, Energiedichte E ≈ 30 J/cm². Nach der Bestrahlung wird durch Behandeln mit Dichlormethan entwickelt, wobei die belichtete Stelle auf dem Siliciumwafer zurückbleibt; die Schichtdicke beträgt ca. 20 µm.

### Beispiel 2

### Bestrahlung eines Poly(dimethylsiloxans)

Ein Poly(dimethylsiloxan) folgender Struktur 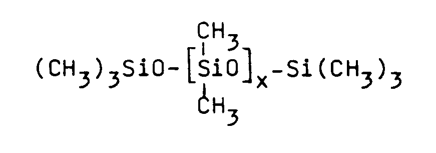
mit einer Viskosität von 1000 mPa.s (bei 25°C) wird mittels Spin-coating auf einen Siliciumwafer aufgebracht. Die Bestrahlung erfolgt in einer Reaktionskammer, die 30 min lang bei einem Druck von 2 . 10⁻⁵ mbar evakuiert wurde. Zur Bestrahlung dient ein ArF-Laser, wobei folgende Bestrahlungsparameter eingehalten werden: unfokussierter Laserstrahl, λ = 193 nm, ν = 50 Hz, t = 30 ns, n = 1000, E ≈ 74 J/cm².
Nach der Bestrahlung wird durch Behandeln mit Dichlormethan entwickelt, wobei die belichtete Stelle auf dem Siliciumwafer zurückbleibt; die Schichtdicke beträgt ca. 2,5 µm.

### Beispiel 3

### Bestrahlung eines Poly(methylphenylsiloxans) mit einem Zusatz eines vinylgruppenhaltigen Siloxans

Ein Poly(methylphenylsiloxan) entsprechend Beispiel 1, dem 0,5 Masse-% eines Methylvinylsiloxan/Dimethylsiloxan-Copolymeren mit einem Vinylgehalt von 7,5 % zugesetzt wurden, wird entsprechend Beispiel 1 auf einen Siliciumwafer aufgebracht und bestrahlt, wobei folgende Bestrahlungsparameter eingehalten werden: unfokussierter Laserstrahl, λ = 266 nm, ν = 10 Hz, t = 10 ns, n = 300, E ≈ 10 J/cm².
Nach der Bestrahlung wird durch Behandeln mit Dichlormethan entwickelt, wobei die belichtete Stelle auf dem Siliciumwafer zurückbleibt; die Schichtdicke beträgt ca. 20 µm.

## Patentansprüche

1. Verfahren zur Erzeugung dünner Schichten auf Siliconbasis durch Photohärtung von Organosiloxanen, **dadurch gekennzeichnet,** daß nichtfunktionalisierte Organosiloxane mit Alkylgruppen oder Alkyl- und Arylgruppen photochemisch - ohne die Verwendung von Photoinitiatoren und/oder Photosensibilisatoren - mittels Impulslaserstrahlung mit einer Wellenlänge < 400 nm polymerisiert und/oder vernetzt werden, wobei die Impulsdauer 10 ps bis 1 ms, die Impulsfrequenz 1 Hz bis 10 kHz und die Energiedichte mindestens 1 J/cm² beträgt und die Bestrahlung mit einem oder mehreren Impulsen erfolgt.

2. Verfahren nach Anspruch 1, **dadurch gekennzeichnet,** daß das Molverhältnis von Arylgruppen zu Alkylgruppen der Organosiloxane maximal 2,0 beträgt und vorzugsweise zwischen 0,001 und 0,5 liegt.

3. Verfahren nach Anspruch 1 oder 2, **dadurch gekennzeichnet,** daß eine Impulslaserstrahlung mit einer Wellenlänge zwischen 190 und 300 nm verwendet wird.

4. Verfahren nach einem der Ansprüche 1 bis 3, **dadurch gekennzeichnet,** daß ein Poly(dimethylsiloxan) eingesetzt wird und die Bestrahlung mit einer Wellenlänge von 193 nm erfolgt.

5. Verfahren nach einem der Ansprüche 1 bis 3, **dadurch gekennzeichnet,** daß ein Poly(methylphenylsiloxan) eingesetzt wird und die Bestrahlung mit einer Wellenlänge von 240 bis 280 nm erfolgt.

6. Verfahren nach einem oder mehreren der Ansprüche 1 bis 5, **dadurch gekennzeichnet,** daß den Organosiloxanen vinylgruppenhaltige Siloxane in einer Menge von 0,5 bis 1,0 Masse-% zugesetzt werden.

7. Verfahren nach einem oder mehreren der Ansprüche 1 bis 6, **dadurch gekennzeichnet,** daß die Bestrahlung in sauerstofffreier Atmosphäre durchgeführt wird.

8. Verfahren nach einem oder mehreren der Ansprüche 1 bis 7, **dadurch gekennzeichnet,** daß durch eine Maske bestrahlt wird.

9. Verwendung der nach dem Verfahren nach einem oder mehreren der Ansprüche 1 bis 7 hergestellten dünnen Schichten als Passivier- und/oder Isolierschicht für diskrete Halbleiterbauelemente und integrierte Halbleiterschaltungen.

10. Verwendung der nach dem Verfahren nach einem oder mehreren der Ansprüche 1 bis 8 hergestellten dünnen Schichten als strukturierte Passivier- und/oder Isolierschicht bei Halbleiterbauelementen.

## Claims

1. Method for generating thin layers on a silicon base through the photo-hardening of organosiloxanes, characterized in that non-functionalized organosiloxanes with alkyl groups or alkyl and aryl groups are photochemically polymerized and/or cross-linked - without the use of photo-initiators and/or photo-sensitizers - by means of pulse laser radiation with a wavelength < 400 nm, whereby the pulse duration amounts to 10 ps to 1 ms, the pulse frequency 1 Hz to 10 kHz and the energy density at least 1 J/cm² and the irradiation takes place with one or more pulses.

2. Method according to claim 1, characterized in that the mole ratio of aryl groups to alkyl groups of the organosiloxanes amounts to a maximum of 2.0 and preferably lies between 0.001 and 0.5.

3. Method according to claim 1 or 2, characterized in that a pulse laser radiation with a wavelength between 190 and 300 nm is used.

4. Method according to one of claims 1 to 3, characterized in that a poly(dimethyl siloxane) is used and the irradiation takes place with a wavelength of 193 nm.

5. Method according to one of claims 1 to 3, characterized in that a poly(methylphenyl siloxane) is used and the irradiation takes place with a wavelength of 240 to 280 nm.

6. Method according to one or more of claims 1 to 5, characterized in that siloxanes containing vinyl groups are added to the organosiloxanes in a quantity of 0.5 to 1.0 % by mass.

7. Method according to one or more of claims 1 to 6, characterized in that the irradiation is carried out in an oxygen-free atmosphere.

8. Method according to one or more of claims 1 to 7, characterized in that the irradiation is carried out through a mask.

9. Use of the thin layers manufactured in accordance with the method according to one or more of claims 1 to 7 as passivating and/or insulating layer for discrete semiconductor components and integrated semiconductor circuits.

10. Use of the thin layers manufactured in accordance with the method according to one or more of claims 1 to 8 as structured passivating and/or insulating layer in semiconductor components.

## Revendications

1. Procédé d'obtention de couches minces à base de silicone par photodurcissement d'organosiloxanes, caractérisé en ce qu'il consiste à polymériser et/ou à réticuler photochimiquement -sans utiliser de photoinitiateur et/ou de photosensibilisateur- des organosiloxanes non fonctionnalisés ayant des groupes alcoyle ou des groupes alcoyle et aryle, par un rayonnement laser pulsé d'une longueur d'onde inférieure à 400 nm, la durée des impulsions étant comprise entre 10 ps et 1 ms, la fréquence des impulsions entre 1 Hz et 10 kHz et la densité d'énergie étant d'au moins 1 J/cm² et l'exposition au rayonnement s'effectuant par une impulsion ou par plusieurs impulsions.

2. Procédé suivant la revendication 1, caractérisé en ce que le rapport molaire des groupes aryle aux groupes alcoyle des organosiloxanes est de 2,0 au plus et, de préférence, est compris entre 0,001 et 0,5.

3. Procédé suivant la revendication 1 ou 2, caractérisé en ce qu'il consiste à utiliser un rayonnement laser pulsé d'une longueur d'onde comprise entre 190 et 300 nm.

4. Procédé suivant l'une des revendications 1 à 3, caractérisé en ce qu'il consiste à utiliser un polydiméthylsiloxane et à effectuer le rayonnement à une longueur d'onde de 193 nm.

5. Procédé suivant l'une des revendications 1 à 3, caractérisé en ce qu'il consiste à utiliser un polyméthylphénylsiloxane et à effectuer le rayonnement à une longueur d'onde de 240 à 280 nm.

6. Procédé suivant l'une ou plusieurs des revendications 1 à 5, caractérisé en ce qu'il consiste à ajouter aux organosiloxanes des siloxanes à groupes vinyliques en une quantité de 0,5 à 1,0 % en poids.

7. Procédé suivant l'une ou plusieurs des revendications 1 à 6, caractérisé en ce qu'il consiste à effectuer l'exposition au rayonnement dans une atmosphère exempte d'oxygène.

8. Procédé suivant l'une ou plusieurs des revendications 1 à 7, caractérisé en ce qu'il consiste à effectuer l'exposition au rayonnement à travers un masque.

9. Utilisation des couches minces préparées par le procédé suivant l'une ou plusieurs des revendications 1 à 7 comme couches de passivation et/ou comme couches isolantes, pour des composants à semiconducteurs discrets et pour des circuits intégrés à semiconducteurs.

10. Utilisation des couches minces préparées par le procédé suivant l'une ou plusieurs des revendications 1 à 8 comme couches passivantes et/ou isolantes structurées dans des composants à semiconducteurs.
